(19) Europäisches Patentamt
European Patent Office
Office européen des brevets

(11) Numéro de publication: **0 207 858**
**A1**

(12) # DEMANDE DE BREVET EUROPEEN

(21) Numéro de dépôt: **86401422.0**

(51) Int.Cl.⁴: **H 03 D 1/22**

(22) Date de dépôt: **27.06.86**

(30) Priorité: **27.06.85 FR 8509774**

(43) Date de publication de la demande:
**07.01.87 Bulletin 87/2**

(84) Etats contractants désignés:
**DE GB IT SE**

(71) Demandeur: **REGIE NATIONALE DES USINES RENAULT**
**Boîte postale 103 8-10 avenue Emile Zola**
**F-92109 Boulogne-Billancourt(FR)**

(72) Inventeur: **Bosquain, Denis**
**69, avenue de la République**
**F-92500 Rueil Malmaison(FR)**

(54) **Circuit de détection synchrone.**

(57) Circuit de détection synchrone d'un signal d'entrée ( h(t) ) en fonction d'un signal de référence ( R(e) ) en créneaux par intégration à l'aide d'au moins un condensateur (C), caractérisé par le fait que le condensateur (C) est monté selon une diagonale d'un pont formé de quatre commutateurs ($K_1$-$K_4$) et dont l'autre diagonale est montée en contre-réaction entre la sortie et l'entrée inverseuse (-) d'un amplificateur opérationnel (AO) recevant également le signal d'entrée à travers une résistance de charge (R), les deux paires ($K_1$, $K_3$; $K_2$, $K_4$) de deux commutateurs opposés étant commandées par un circuit de séquencement approprié.

FIG.2

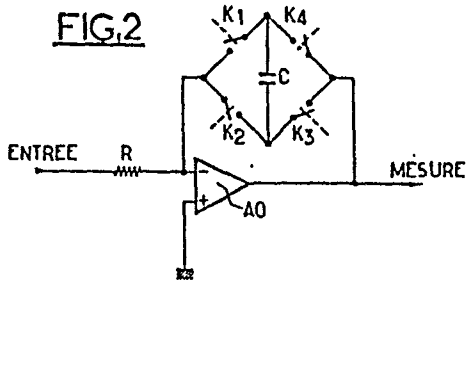


EP 0 207 858 A1

Circuit de détection synchrone.

L'invention concerne la détection synchrone, moyen connu et fréquemment utilisé pour mesurer sélectivement un signal analogique noyé dans du bruit.

On en connaît des réalisations pratiques sous la forme d'appareils de laboratoire dans lesquels on peut ajuster tous les paramètres de signal de référence, fréquence, phase et durée. Cette détection se trouve exploitée dans de nombreux appareils de mesure et dans certains montages délicats tels que radars, récepteurs radio à haute performance, démodulateurs d'amplitude et de phase, corrélateurs.

Du point de vue théorique, cette détection synchrone est basée sur la réalisation de la corrélation

$$\int_{t1}^{t2} h(t).R(t).dt$$

dans laquelle

h(t) est l'ensemble du signal et du bruit, et

R(t) est le signal de référence sinusoïdal $R(t) = e^{2j\pi(ft + j\emptyset}$ avec les notations habituelles, c'est-à-dire variable temps t, fréquence f et décalage de phase $\emptyset$ (et j le facteur "imaginaire" des nombres complexes).

Une telle corrélation est difficile à réaliser car elle nécessite soit un multiplicateur analogique avec fonction non linéaire, soit un traitement numérique, ce qui conduit toujours à des réalisations hautement sophistiquées et onéreuses.

C'est pourquoi il est fréquent, au prix d'une dégradation des performances et lorsque l'application le permet, de remplacer le signal de référence sinusoïdal par un signal rectangulaire symétrique. Le multiplicateur se trouve alors remplacé par un simple inverseur de signal, comme illustré sur le schéma théorique de la figure 1 qui représente l'état de la technique.

Le but de l'invention est de simplifier la réalisation de ce schéma de principe, en diminuant le nombre de composants, en réduisant les contraintes sur les performances de ces composants, en éliminant les réglages de mise au point et en permettant enfin l'utilisation de circuits intégrés de grande diffusion.

L'invention consiste pour l'essentiel à monter un condensateur selon une diagonale d'un pont formé de quatre commutateurs et dont l'autre diagonale est montée en contre réaction entre la sortie et l'entrée inverseuse d'un amplificateur opérationnel recevant également le signal d'entrée à travers une impédance de charge, les deux paires de deux commutateurs opposés étant commandées par un séquenceur approprié.

D'autres particularités de l'invention apparaîtront dans la description qui va suivre de divers modes de réaliation et d'application pris comme exemples et représentés sur le dessin annexé sur lequel :

- la figure 1, comme déjà mentionné, représente l'état de la technique,
- la figure 2 le schéma de principe à la base de l'invention,
- la figure 3 le schéma d'une application à intégration continue,
- la figure 4 le schéma d'une application à intégration pendant un temps limité,
- la figure 5 le schéma d'un circuit de charge initiale,
- la figure 6 le schéma d'une détection de seuil,
- la figure 7 le chronogramme d'un exemple de séquencement,
- la figure 8 le schéma d'une détection de seuil avec hystérésis,
- la figure 9 le schéma d'une modification avec entrées différentielles,
- la figure 10 un exemple de chronogramme du séquencement correspondant à la figure 9, et
- les figures 11, 12 et 13 les chronogrammes d'exemples limites du séquencement.

Comme illustré sur la figure 2, le détecteur synchrone selon l'invention met en oeuvre un condensateur C commuté par un pont de quatre commutateurs $K_1$, $K_2$, $K_3$ et $K_4$ dans un montage intégrateur comprenant une résistance d'entrée R et un amplificateur opérationnel AO pour lequel le circuit, comprenant le condensateur C et les quatre

commutateurs, est monté en contre réaction entre sa sortie et son entrée inverseuse (-).

On suppose tout d'abord, pour la commodité de l'exposé, que le condensateur C est initialement déchargé, et que le signal h(t) que l'on cherche à analyser est un signal périodique rectangulaire symétrique d'amplitude $\pm A$ et de période T.

Pendant la première demi-période d'alternance positive, les interrupteurs $K_1$ et $K_3$ sont fermés, tandis que $K_2$ et $K_4$ sont ouverts. A la fin de cette première demi-période le condensateur s'est chargé à une tension

$$-(1/RC).\int_0^{T/2} A.dt = - AT/2RC$$

On ouvre alors les interrupteurs $K_1$ et $K_3$ de manière que la charge du condensateur soit conservée, et on ferme les interrupteurs $K_2$ et $K_4$ pour intégrer la deuxième demi-période d'alternance négative :

$$-(1/RC).\int_0^{T/2} (-A).dt = AT/2RC$$

La charge correspondante s'additionne à la précédente dans le condensateur et dans le même sens puisque son sens de connexion s'est inversé. On ouvre alors les interrupteurs $K_2$ et $K_4$ et le cycle reprend pour l'alternance suivante qui est positive.

Au bout d'un certain nombre de cycles, la charge du condensateur atteint une valeur que l'on peut mesurer facilement à ses bornes et qui est représentative de l'amplitude du signal d'entrée.

Pour que ce montage fonctionne correctement, il est nécessaire de prendre certaines précautions :

1°) il faut éviter le recouvrement des temps de conduction des paires d'interrupteurs $K_1$, $K_3$ et $K_2$, $K_4$ qui déchargerait brutalement le condensateur. A cet effet il suffit de prévoir une légère avance des ouvertures sur les fermetures.

2°) Il faut éviter le saturation des circuits, et en particulier de l'amplificateur opérationnel AO, ce qui s'obtient par

- une limitation des niveaux d'entrée,

- un choix judicieux de R, de C et de la durée d'intégration en fonction du niveau d'entrée,

– le montage d'un circuit limiteur de tension surle condensateur qui interdise à l'amplificateur de se bloquer (latch-up) à l'occasion d'une inversion de polarité par exemple.

Tous ces moyens et leur mise en oeuvre sont bien connus de l'homme de l'art.

3°) Si l'on cherche à éviter absolument un comportement aléatoire de l'amplificateur opérationnel lors des instants de commutation, on peut prévoir une petite capacité G montée en contre-réaction permanente sur l'amplificateur, c'est-à-dire en parallèle avec le pont de commutateurs. On peut montrer que dans ce cas le circuit se comporte comme le circuit précédent mais dans lequel le condensateur C serait remplacé par une capacité équivalente C + 3G, à condition que G soit relativement petit devant C.

D'un point de vue théorique, on sait que pour un signal à l'entrée

$$h(t) = Ae^{2j\pi ft + j\emptyset}$$

et un signal de référence R(t) rectangulaire, composé de n périodes à la fréquence F, la tension finale aux bornes sera

$$A(je^{j\emptyset}/2\pi f).(1-e^{j\pi f/F})^2.(1-e^{2j\pi nf/F})/(1-e^{2j\pi f/F})$$

Cette valeur est nulle pour f = 0, 2F, 4F...2kF

f = F/n, 2F/n, 3F/n...(2k+1)F/n

mais non pour f = F, 3F, 5F...(2k+1)F où elle est maximale. Pour ces dernière valeurs, si la phase est appropriée, les maxima valent

$$2nA/(2k+1).\pi F$$

Il est classique d'éliminer les composantes indésirables, autres que f = F, par un filtre passe-bas à l'entrée. Mais le véritable intérêt du montage selon l'invention est d'ordre pratique :

1°) l'élimination de la composante continue f = 0 permet d'utiliser un amplificateur opérationnel AO peu performant en termes de dérive et d'offset;

2°) par ailleurs le courant de charge du condensateur ne dépend pas de la résistance résiduelle des interrupteurs fermés, ce qui permet d'employer de simples transistors MOS.

En définitive les performances du circuit ne dépendent que
- de la linéarité de l'amplificateur,
- de la rapidité de cet amplificateur,
- de l'absence de fuites autour du condensateur, et
- du nombre total de périodes d'intégration.

La cellule de détection synchrone à capacité commutée telle qu'elle vient d'être décrite se prête à de nombreuses applications qui se distinguent notamment par le caractère continu ou limité de l'intégration.

Dans le cas d'une mesure avec intégration continue, on part du schéma de la figure 2 et on réalise une configuration en filtre passe-bas en rajoutant une résistance r en parallèle avec le condensateur C. De préférence, comme représenté sur la figure 3, cette résistance r est placée également en dérivation sur le pont de commutateur de manière à rester en permanence en contre-réaction sur l'amplificateur AO afin d'obtenir une meilleure précision de fonctionnement. Ce montage s'applique particulièrement à la réalisation de modulateurs-démodulateurs.

Si l'on veut réaliser une intégration pendant un temps limité et une mesure périodique, il faut alors prévoir un cycle à trois phases :

- au cours de la première phase on donne une valeur initiale connue à la charge du condensateur C,

- au cours de la deuxième phase on fait fonctionner la cellule comme il a été décrit pendant un certain nombre d'alternances,

- enfin au cours de la troisième phase on mesure la charge finale du condensateur.

D'une manière générale, la mise en oeuvre de ces diverses phases est assurée par des circuits auxiliaires représentés sur la figure 4, où l'on voit en plus du circuit de détection synchrone à capacité commutée référencé DSCC :

- une porte P fonctionnant comme un simple interrupteur et destinée à couper le signal d'entrée lorsque sa présence dans le circuit risquerait d'être perturbatrice;

- une circuiterie de remise à zéro RAZ, destinée à fixer la charge initiale du condensateur,

- un compteur de cycles COMPT, qui fixe la durée totale de la détection-intégration;

- un dispositif d'échantillonnage de charge finale E qui permet au circuit de mesure M de travailler "au vol"; et

- un circuit de séquencement S qui arrête la durée et la suite logique des différentes phases de fonctionnement.

De plus on a représenté sur cette figure 4 une application particulière dans laquelle le signal d'entrée provient d'un capteur CP modulant le signal de référence en amplitude ou en phase. Un déphaseur dØ est souvent nécessaire pour faire fonctionner le détecteur avec des relations de phase correctes entre le signal d'entrée et le signal de référence provenant de l'horloge de référence Hr.

Dans un premier mode de réalisation, la valeur initiale de la charge du condensateur au début de chaque cycle est nulle, et la remise à zéro périodique est obtenue avantageusement par la fermeture simultanée de deux commutateurs successifs, par exemple $K_1$ et $K_2$, ou encore des quatre commutateurs du pont. Il peut être nécessaire de limiter le courant au cours de cette opération en plaçant en série avec le condensateur C une résistance non représentée de limitation de courant pour protéger les commutateurs, une telle résistance ne modifiant en rien le fonctionnement normal de la cellule de détection.

A la fin de la phase d'intégration, la mesure de la charge finale du condensateur C peut s'effectuer soit directement, en ouvrant tous les commutateurs $K_1$, $K_2$, $K_3$ et $K_4$ et on connectant le condensateur au circuit de mesure, soit plus avantageusement en transformant la cellule de détection en échantillonneur-bloqueur par le jeu des commutateurs et en agissant sur le commutateur d'entrée P pour déconnecter le signal d'entrée pendant l'échantillonnage. La valeur ainsi bloquée est l'échantillon de la valeur finale, à la polarité près que l'on peut choisir en fonction des besoins. Par exemple en ouvrant le commutateur d'entrée P et en laissant $K_2$ et $K_4$ ouverts tandis que $K_1$ et $K_3$ sont fermés on obtient un niveau de mesure stable.

Dans un autre mode de réalisation, destiné à mieux exploiter l'excursion de tension à la sortie de l'amplificateur, la charge initiale du condensateur C est fixée à une valeur positive, par exemple +V/2 si +V et -V sont les tensions d'alimentation. Il faut donc rajouter à la cellule de détection un circuit de charge initial spécifique tel que celui représenté sur la figure 5. On voit sur cette figure le commutateur d'entrée P ainsi qu'un commutateur d'initialisation Ki qui relie l'entrée en aval de P à la tension d'alimentation -V et qui est commandé par une bascule B de type D avec remise à zéro par front montant. Cette commande de remise à zéro de la bascule B est raccordée à la sortie d'un comparateur CO dont l'entrée directe est raccordée à la sortie de la cellule de détection, c'est-à-dire à la sortie de AO, et dont l'entrée inverseuse est raccordée à une source de tension de référence Ref de valeur V/2.

L'entrée de signal étant déconnectée par P, et l'une des paires d'interrupteurs étant fermée, par exemple $K_2$ et $K_4$ sur la figure 5, un signal "start" référencé ST actionne la bascule B qui ferme le commutateur Ki, lequel raccorde l'entrée de la cellule de détection sur la tension négative -V. Au bout d'un certain temps, la tension de sortie de la cellule de détection atteint la tension de référence V/2 et fait basculer le comparateur CO, et par conséquent la bascule B, ce qui ouvre le commutateur Ki. La charge des condensateurs C se maintient alors à V/2 jusqu'à ce que commence la phase de détection-intégration.

Bien entendu lors de la mesure de la valeur finale, on tient compte de cette charge initiale, par exemple en prenant cette même tension V/2 comme référence au lieu de la masse lors de l'échantillonnage. Dans tous les cas une tension de référence stabilisée est préférable à une tension de référence dérivée de la tension d'alimentation.

En variantes sur ce qui précède, la phase de charge initiale peut opérer comme suit : dans un premier temps on opère comme précédemment mais en remplaçant la tension négative -V par +V et la tension de référence V/2 par -V/2; puis dans une deuxième phase on change la polarité de la charge de C par le jeu des commutateurs en pont en fermant la paire ouverte et en ouvrant la paire fermée.

Ces mêmes perfectionnements restent applicables dans le cas d'un montage à tension d'alimentation unique (O,+V) où l'on pourra prendre une référence de signal d'entrée à +V/2 (au lieu de -V) et une référence de charge Ref à V/4 ou +3V/4 (au lieu de V/2). Dans tous les cas de charge initiale non nulle, le cycle de charge initiale qui vient d'être examiné devra être précédé d'une phase initiale au cours de laquelle :

- soit on court-circuite le condensateur C pour le décharger comme exposé plus haut à propos de la charge nulle,
- soit on commence par tester son état initial à l'aide du comparateur CO, et, si la charge de référence est dépassée, on échange d'abord la polarité par le jeu des interrupteurs du pont, alors que l'on ne fait pas cet échange de polarité dans le cas contraire.

Pour certaines applications, la valeur mesurée importe moins par sa valeur exacte que par le fait qu'elle dépasse un certain seuil, en relation avec un phénomène dont on veut décider si il a eu lieu ou non. Par exemple un cas typique est celui de la détection de passage d'objets devant un capteur magnétique, capacitif ou optoélectronique.

Pour cela on peut tout naturellement, dans le schéma général de la figure 4, remplacer le circuit de mesure M par un comparateur à seuil. Il est cependant plus avantageux dans le cas de l'invention de réutiliser le comparateur CO qui a déjà servi à fixer la charge initiale du condensateur. Le seuil peut être le même si l'on exploite la variante indiquée ci-dessus avec inversion de polarité lors de la charge initiale.

La figure 6 montre l'exemple d'une telle réalisation. On y retrouve les mêmes éléments que sur la figure 5, avec les mêmes références, sauf que la tension d'alimentation +V est appliquée par le commutateur Ki à travers une résistance $R_1$ distincte de R, et que le signal de sortie du comparateur CO attaque l'entrée d'une bascule de synchronisation L (Latch) dont la sortie logique indique s'il y a ou non détection d'un objet par le capteur CP de la figure 4. On a reporté également sur cette figure le compteur-séquenceur S de la figure 4 qui synchronise tous les composants actifs.

La figure 7 donne à titre d'exemple un chronogramme du séquencement possible du dispositif de la figure 6, compte tenu du fait que l'on peut adopter d'autres conventions de polarité, prolonger certaines phases, introduire des temps morts, commencer l'intégration par une alternance négative plutôt que positive et lui donner la durée qui convient à chaque application.

En particulier il faut noter que seule la phase II d'intégration-redressement doit être synchrone de l'horloge de référence Hr, alors qu'aucun synchronisme n'est nécessaire pour les deux autres phases, I de charge initiale et III d'échantillonnage.

Pour certaines applications on peut désirer vérifier plusieurs fois de suite que le seuil de décision a été dépassé, traduisant ainsi le maintien de la condition qui a provoqué le dépassement, comme c'est le cas par exemple d'un capteur de passage d'objets "voyant" un objet immobile devant lui. Si le seuil était juste dépassé, un faible niveau de bruit pourrait produire des fluctuations indésirables du signal de sortie logique qui oscillerait entre détection et non détection.

Cette difficulté est classiquement résolue par l'introduction d'hystérésis sur le seuil de détection : une première détection abaisse le seuil, une première non détection relève le seuil.

Dans le cas du détecteur selon l'invention, la mise en oeuvre d'un tel hystérésis est particulièrement simple : il suffit d'agir sur la référence de charge initiale du condensateur, ou sur le seuil de comparaison final, ou les deux à la fois, en fonction de la conclusion du cycle de détection précédent.

Un exemple de réalisation est donné sur la figure 8, où l'on retrouve sous les mêmes références une partie des éléments de la figure 6. La seule différence est que la source de référence Ref de la figure 6 est remplacée ici par deux sources de référence Ref1 et Ref2 de tensions différentes commutées alternativement, par exemple sur le comparateur CO, par un commutateur d'hystérésis Kh actionné par le niveau logique de la sortie de L.

Il est fréquent en traitement de signal d'utiliser des entrées différentielles pour éliminer des bruits parasites existant entre la

référence de la source du signal d'une part, et la référence du détecteur synchrone d'autre part. On pourrait sans difficulté introduire devant le circuit de détection synchrone un amplificateur différentiel d'une manière connue. Mais le détecteur synchrone selon l'invention, au prix de légères modifications et de très peu de composants supplémentaires, offre la possibilité de réaliser une approximation de la même fonction.

En effet, le signal de sortie du détecteur synchrone à capacité commutée selon l'invention ne dépend que de la phase relative des signaux d'entrée et des signaux internes régissant la commande des commutateurs en pont du condensateur. Ainsi, comme représenté sur la figure 9, un commutateur $P_2$ à deux voies à l'entrée, associé à une inversion de phase des signaux internes de référence, permet de faire la différence de deux signaux d'entrée $E_1$ et $E_2$.

Selon un mode de réalisation avantageux, les deux voies $E_1$ et $E_2$ sont entrelacées période par période. Il en résulte

- une meilleure élimination des bruits parasites de courte durée en mode commun;
- une division par deux de la fréquence de commutation des interrupteurs du pont, ce qui est favorables à un bon fonctionnement; et
- une meilleure utilisation de l'excursion de tension utile à la sortie de l'amplificateur opérationnel.

Les signaux de commande typique d'un tel montage sont représentés par le chronogramme de la figure 10, sur laquelle on reconnaît les trois phases de fonctionnement de chaque cycle déjà exposées. Hr est l'horloge de référence, $E_1$ est le signal de commande de l'interrupteur de l'entrée de la première voie, $E_2$ est le signal de commande de l'interrupteur de l'entrée de la deuxième voie, I+ est le signal de commande des interrupteurs $K_1$ et $K_3$, et I- est le signal de commande des interrupteurs $K_2$ et $K_4$.

On a fait figurer en outre, aux strictes fins d'une meilleure compréhension, le signal s qui apparaîtrait à la sortie de l'amplificateur AO selon le séquencement exposé et dans le cas très simple où l'entrée de la première voie reçoit l'horloge de référence et où l'entrée de la deuxième voie est mise à la masse.

Naturellement toutes les variantes et perfectionnements décrits précédemment pour un détecteur synchrone selon l'invention à une seule entrée peuvent s'appliquer à cette dernière réalisation à entrées différentielles.

Il faut toutefois prendre garde au fait que la réponse en fréquence, amplitude et phase de ce dernier montage diffère de celle d'un détecteur synchrone intégrateur habituel précédé d'un amplificateur différentiel classique.

En effet pour un signal d'entrée $h(t) = A\, e^{2j\pi ft + j\emptyset}$ on trouvera en sortie, après 2n périodes d'intégration à la fréquence F,

pour l'entrée $E_1$

$$A1(je^{j\emptyset}/2\pi f).(1-e^{j\pi f/F})^2.(1-e^{4j\pi nf/F})/(1-e^{4j\pi f/F})$$

pour l'entrée $E_2$

$$-A2(je^{j\emptyset}/2\pi f).(1-e^{j\pi f/F})^2.(1-e^{4j\pi nf/F})e^{2j\pi f/F}/(1-e^{4j\pi f/F})$$

pour le mode commun aux deux entrées

$$A(je^{j\emptyset}/2\pi f).(1-e^{j\pi f/F})^2.(1-e^{4j\pi nf/F})/(1+e^{2j\pi f/F})$$

On voit qu'il apparaît une sensibilité aux fréquences $f = F/2, 3F/2...(2k+1)F/2$ du même ordre de grandeur que celle de la fréquence désirée $f = F$.

Cette sensibilité du mode commun $E_1+E_2$ aux nombres impairs de demi-fréquences peut être gênante pour la plupart des applications, et l'adjonction de filtres auxiliaires ne constitue pas une solution avantageuse.

Pour éliminer cette sensibilité du mode commun aux nombres impairs de demi-fréquences on peut selon l'invention inverser périodiquement l'ordre de scrutation dans le temps des entrées $E_1$ et $E_2$, de sorte que la phase du signal pertubateur s'inverse et par conséquent son influence s'annule lorsque le cycle complet de détection-intégration est ainsi découpé en un nombre pair de sous-cycles.

La figure 11 donne un exemple de chronogramme de la phase d'intégration seule (III) dans le cas de deux sous-cycles. Bien entendu la durée des sous-cycles consécutifs, un direct et un inversé, est à ajuster en fonction de la durée moyenne des éventuels signaux perturbateurs.

A la limite, la durée minimale d'un de ces sous-cycles et de deux périodes d'horloge de référence, et les signaux de commande sont alors ceux représentés sur la figure 12 ou 13.

Le biphase de la figure 12 présente l'avantage de commuter le condensateur à la fréquence F/4, mais possède une sensibilité élevée en mode commun aux signaux parasites dont les fréquences sont un nombre impair de quarts de fréquence (2k+1)F/4. Le biphase de la figure 13 y est un peu moins sensible, dans le rapport $(\sqrt{2} - 1)/2$.

Les séquences des figures 12 et 13 sont donc particulièrement intéressantes dans le cas où l'environnement est fortement perturbé aux fréquences qui sont des nombres impairs de demi-fréquences sans pour autant l'être aux fréquences qui sont des nombres impairs de quarts de fréquence.

## REVENDICATIONS

1. Circuit de détection synchrone d'un signal d'entrée ( h(t) ) en fonction d'un signal de référence ( R(e) ) en créneaux par intégration à l'aide d'au moins un condensateur (C), caractérisé par le fait que le condensateur (C) est monté selon une diagonale d'un pont formé de quatre commutateurs ($K_1$-$K_4$) et dont l'autre diagonale est montée en contre-réaction entre la sortie et l'entrée inverseuse (-) d'un amplificateur opérationnel (AO) recevant également le signal d'entrée à travers une résistance de charge (R), les deux paires ($K_1$, $K_3$; $K_2$, $K_4$) de deux commutateurs opposés étant commandées par un circuit de séquencement approprié.

2. Circuit de détection synchrone selon la revendication 1 avec mode de fonctionnement à intégration continue, caractérisé par le fait qu'il comporte une configuration en filtre passe-bas par addition d'une résistance supplémentaire en parallèle avec le condensateur (C).

3. Circuit de détection selon la revendication 2, caractérisé par le fait que ladite résistance supplémentaire (r) est montée en dérivation sur le circuit contenant le pont de commutateurs ($K_1$-$K_4$) (figure 3).

4. Circuit de détection synchrone selon la revendication 1, avec modes de fonctionnement à intégration pendant un temps limité et mesure périodique, caractérisé par le fait qu'il comporte en outre

- une porte d'entrée (P) permettant d'établir ou d'interrompre la connexion avec le signal d'entrée,
- un moyen (RAZ) destiné à communiquer une valeur initiale connue à la charge du condensateur (C) au cours d'une première phase (I) de chaque cycle de fonctionnement,
- un moyen de comptage (COMPT) commandant les commutateurs en pont ($K_1$-$K_3$) pour assurer la détection synchrone pendant une deuxième phase d'intégration définie par un certain nombre d'alternances de l'horloge de référence ($H_2$) fournissant ledit signal de référence,
- un moyen d'échantillonnage (E) fournissant le signal au moyen de mesure, et

- un séquenceur (S) assurant la synchronisation des quatre moyens précédents.

5. Circuit de détection synchrone selon la revendication 4, caractérisé par le fait que ladite valeur initiale de la charge du condensateur est nulle, et que ledit moyen de charge initiale (RAZ) est constitué par un moyen de commande pour fermer simultanément au moins deux successifs des quatre commutateurs en pont ($K_1$-$K_4$), avec éventuellement une résistance de limitation de courant en série avec le condensateur.

6. Circuit de détection synchrone selon l'une des revendications 4 et 5, caractérisé par le fait que ledit moyen d'échantillonnage (E) est constitué par une phase de commande agissant sur la porte d'entrée (P) dans le sens de l'ouverture et sur les commutateurs en pont pour ouvrir une paire de commutateurs opposés et fermer l'autre paire, la paire choisie étant fonction du signe voulu pour le signal.

7. Circuit de détection synchrone selon la revendication 4, caractérisé par le fait que ladite valeur initiale de la charge du condensateur (C) est fixée à une valeur non nulle (Ref), et que le moyen (RAZ) de charge initiale comporte un commutateur (Ki) de charge initiale assurant l'alimentation du circuit intégrateur à une tension d'alimentation (V) après ouverture de la porte d'entrée (P), une phase de commande fermant en permanence deux opposés ($K_2$, $K_4$) des interrupteurs du pont, un comparateur (CO) comparant le signal de sortie de l'amplificateur opérationnel (AO) à la tension de référence (Ref), et une bascule (B) commandant l'ouverture du commutateur (Ki) de charge, lorsque ledit comparateur (CO) a détecté que la charge du condensateur a atteint cette valeur de référence.

8. Circuit de détection synchrone selon la revendication 7, caractérisé par le fait que la phase de charge initiale se termine par une dernière phase d'inversion de polarité par action sur les commutateurs du pont pour ouvrir la paire fermée et fermer la paire ouverte.

9. Circuit de détection synchrone selon une des revendications 7 et 8, caractérisé par le fait que la phase de charge initiale à une valeur non nulle est précédée par une mise à zéro de la charge conformément à la revendication 5.

10. Circuit de détection synchrone selon l'une des revendications 7 et 8, caractérisé par le fait que la phase de charge initiale à une valeur non nulle est précédée par une phase de test vérifiant l'état initial de charge du condensateur à l'aide du même comparateur (CO), et agissant, seulement dans le cas où la charge dépasse la valeur de référence, pour inverser la polarité par une action sur les interrupteurs du pont de manière à fermer la paire ouverte et ouvrir la paire fermée.

11. Circuit de détection synchrone selon une des revendications 7 à 10, dans lequel la sortie analogique de l'amplificateur opérationnel (AO) est transformée en sortie logique en fonction du dépassement ou du non dépassement d'un seuil par ce signal analogique, caractérisé par le fait que la valeur (Ref) de la charge initiale du condensateur est choisie à la même valeur que ledit seuil, et qu'on utilise le même comparateur (CO) pour fournir le signal de sortie logique à travers une bascule de synchronisation (L).

12. Circuit de détection synchrone selon la revendication 11, caractérisé par le fait que le seuil de détection est doté d'un hystérésis par utilisation de deux sources de référence (Ref1, Ref2) de valeurs différentes et d'un commutateur d'hystérésis (Kh) actionné par ladite sortie logique pour sélectionner la source convenable.

13. Circuit de détection synchrone selon l'une des revendications 4 à 12, caractérisé par le fait que ladite porte d'entrée (P) est remplacée par un commutateur à deux voies ($P_2$) sélectionnant une parmi deux entrées différentielles ($E_1$ et $E_2$) d'une manière entrelacée avec un séquencement approprié et un nombre pair de sous-cycles.

FIG.1

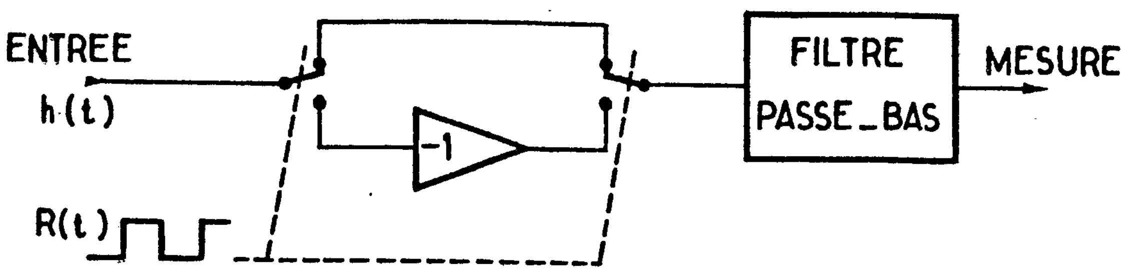


FIG.2

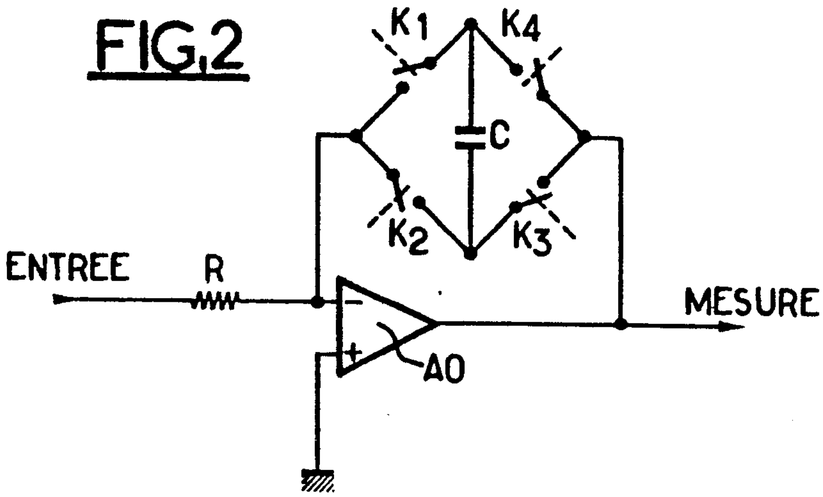


FIG.3

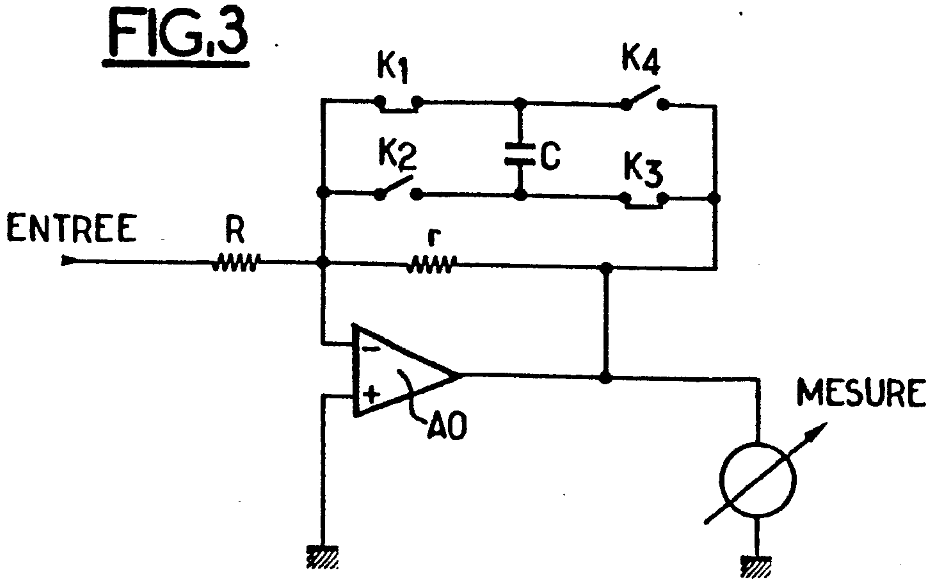

FIG.4

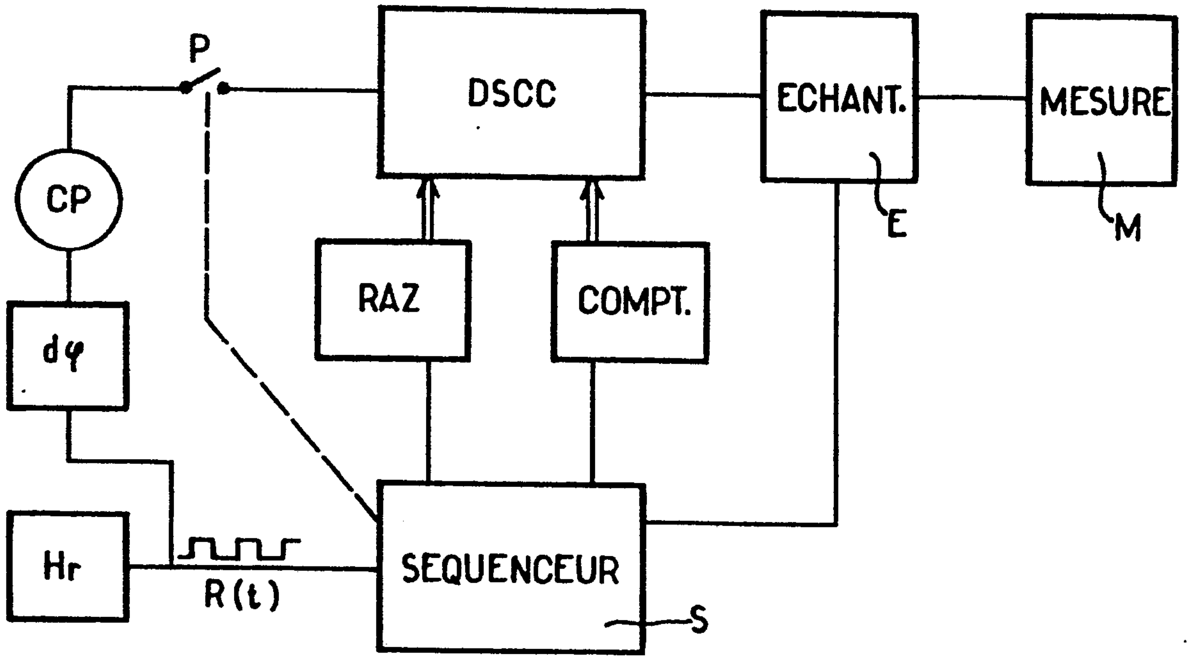
P
DSCC
ECHANT.
MESURE
CP
E
M
RAZ
COMPT.
dφ
Hr
R(t)
SEQUENCEUR
S

FIG.5

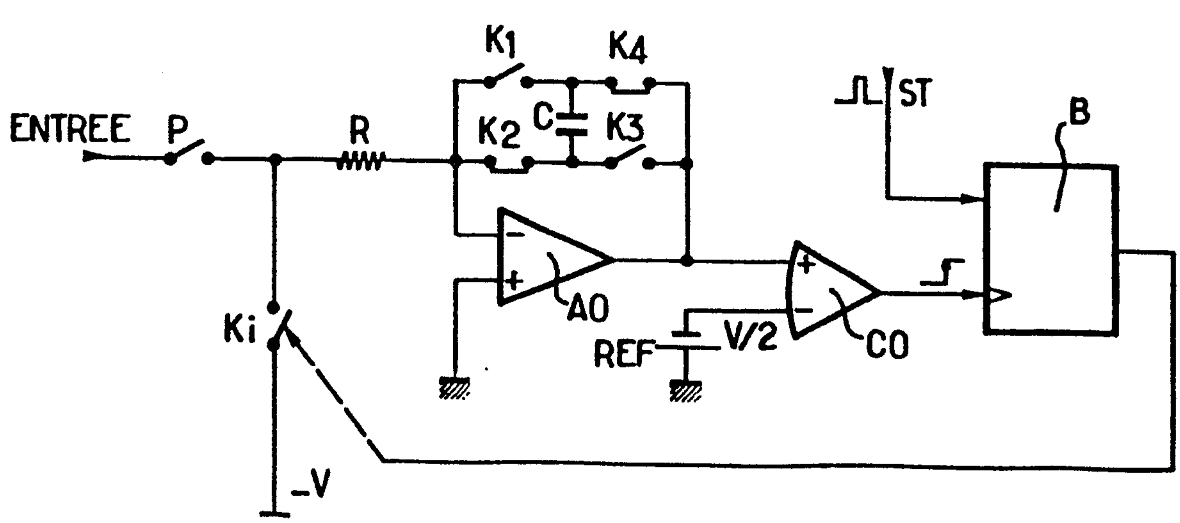
K1
K4
ST
B
ENTREE
P
R
K2
C
K3
A0
Ki
REF
V/2
CO
-V

FIG.6

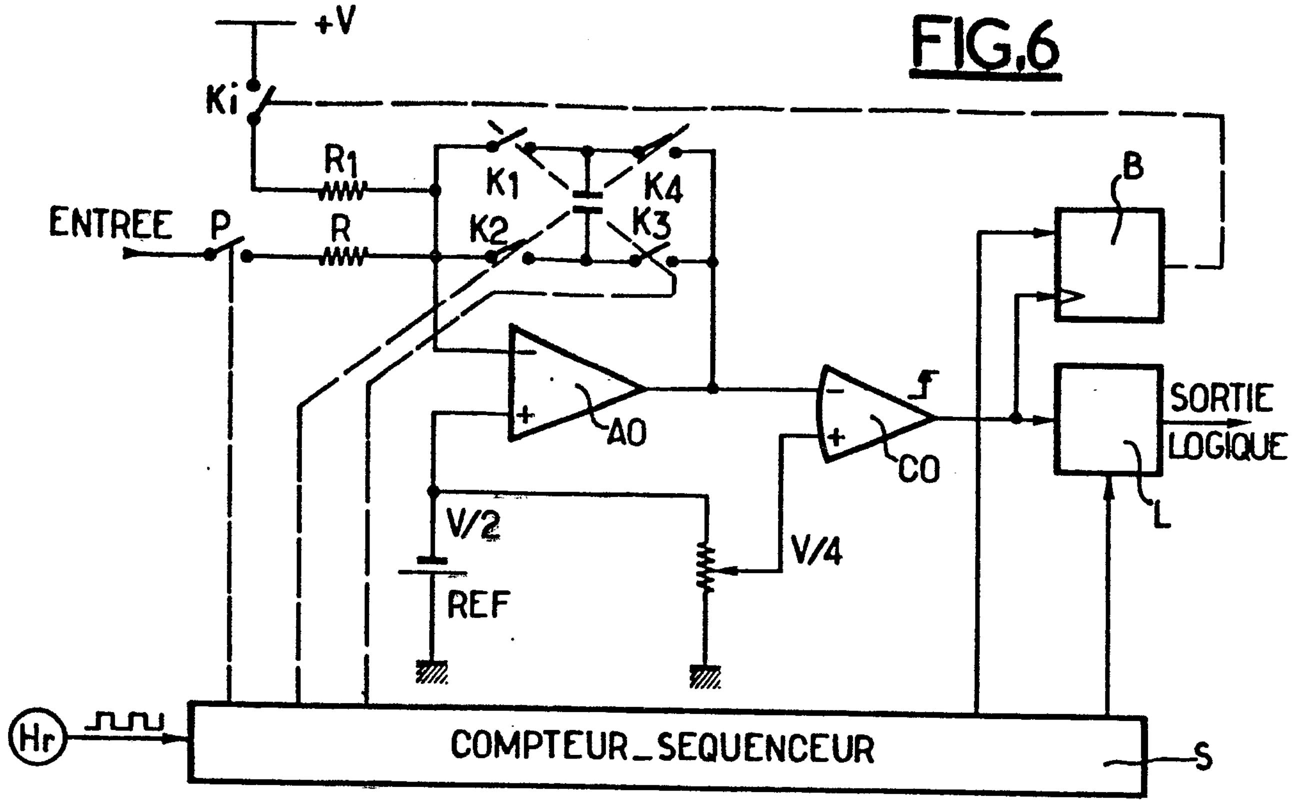
+V
Ki
R1
R
ENTREE
P
K1
K2
K3
K4
B
A0
C0
V/2
REF
V/4
SORTIE
LOGIQUE
L
Hr
COMPTEUR_SEQUENCEUR
S

FIG.7

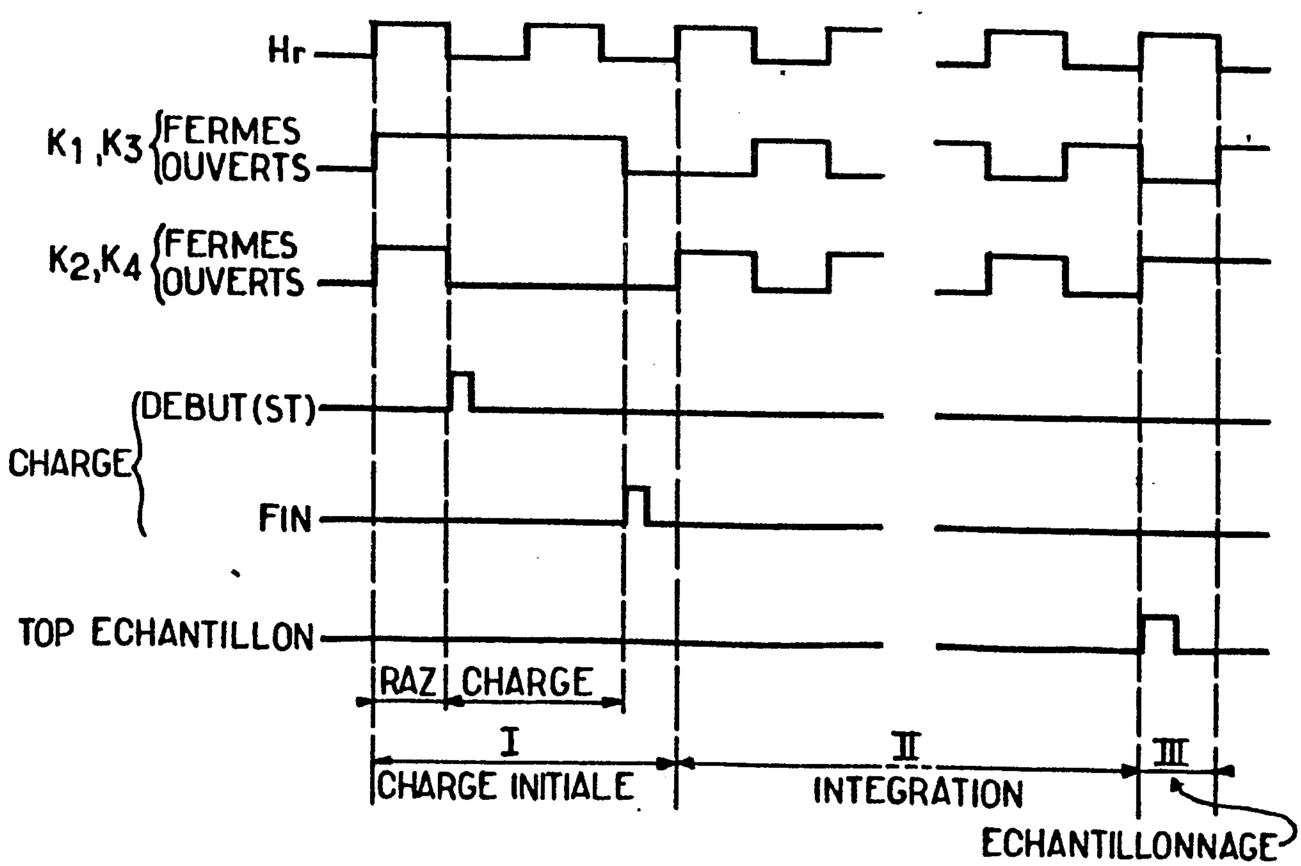
Hr
K1, K3 {FERMES OUVERTS
K2, K4 {FERMES OUVERTS
CHARGE {DEBUT(ST)
FIN
TOP ECHANTILLON
RAZ
CHARGE
I
CHARGE INITIALE
II
INTEGRATION
III
ECHANTILLONNAGE

FIG.8

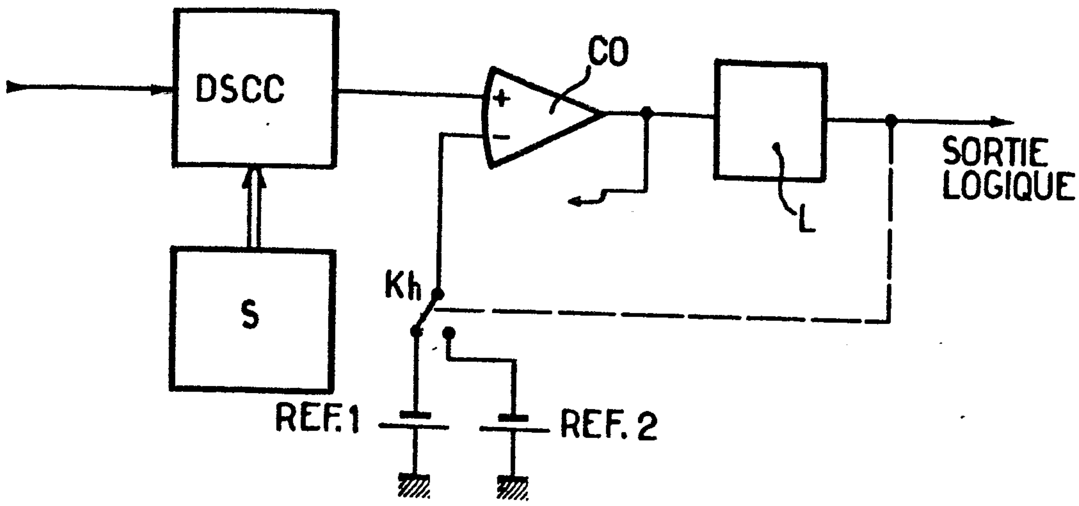


FIG.9

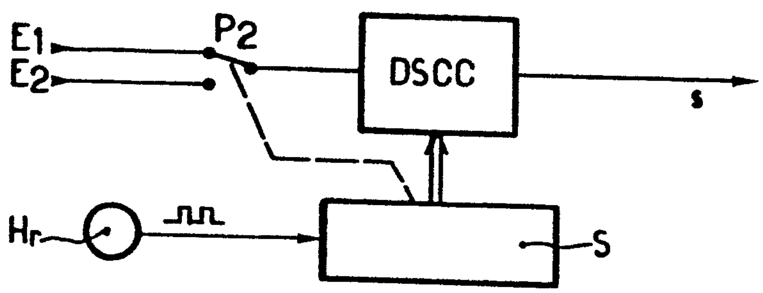


FIG.11

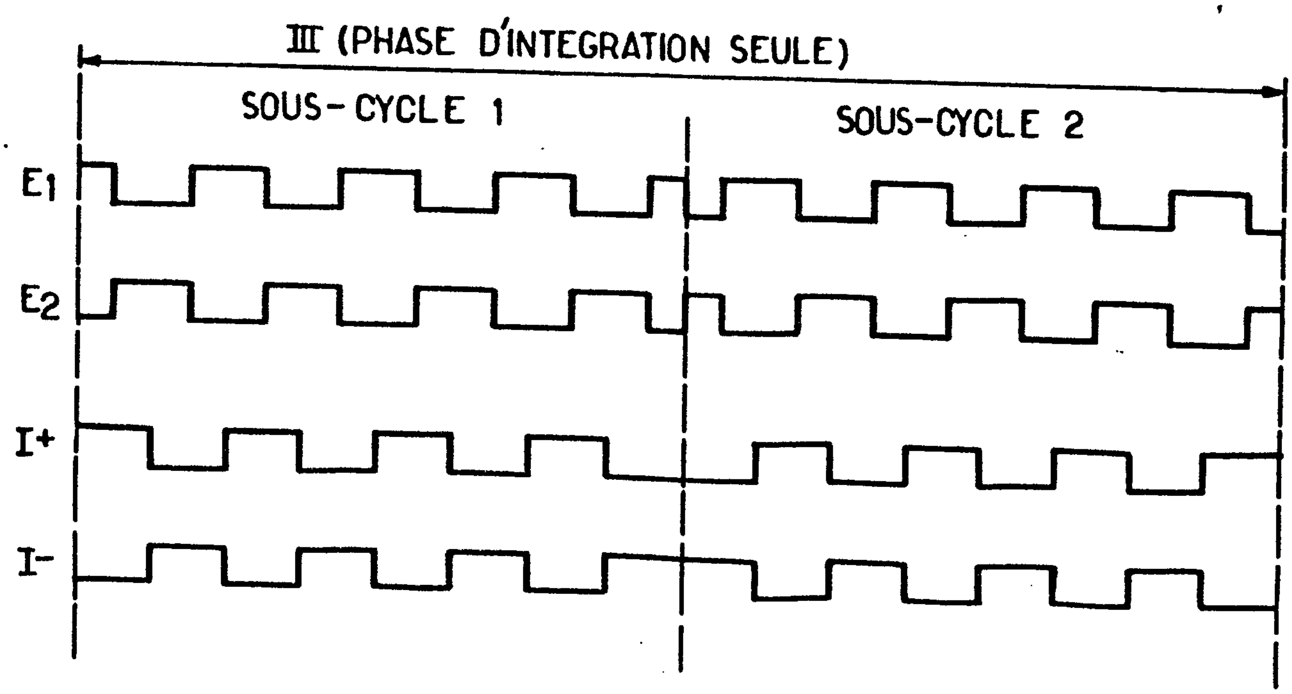

FIG.10

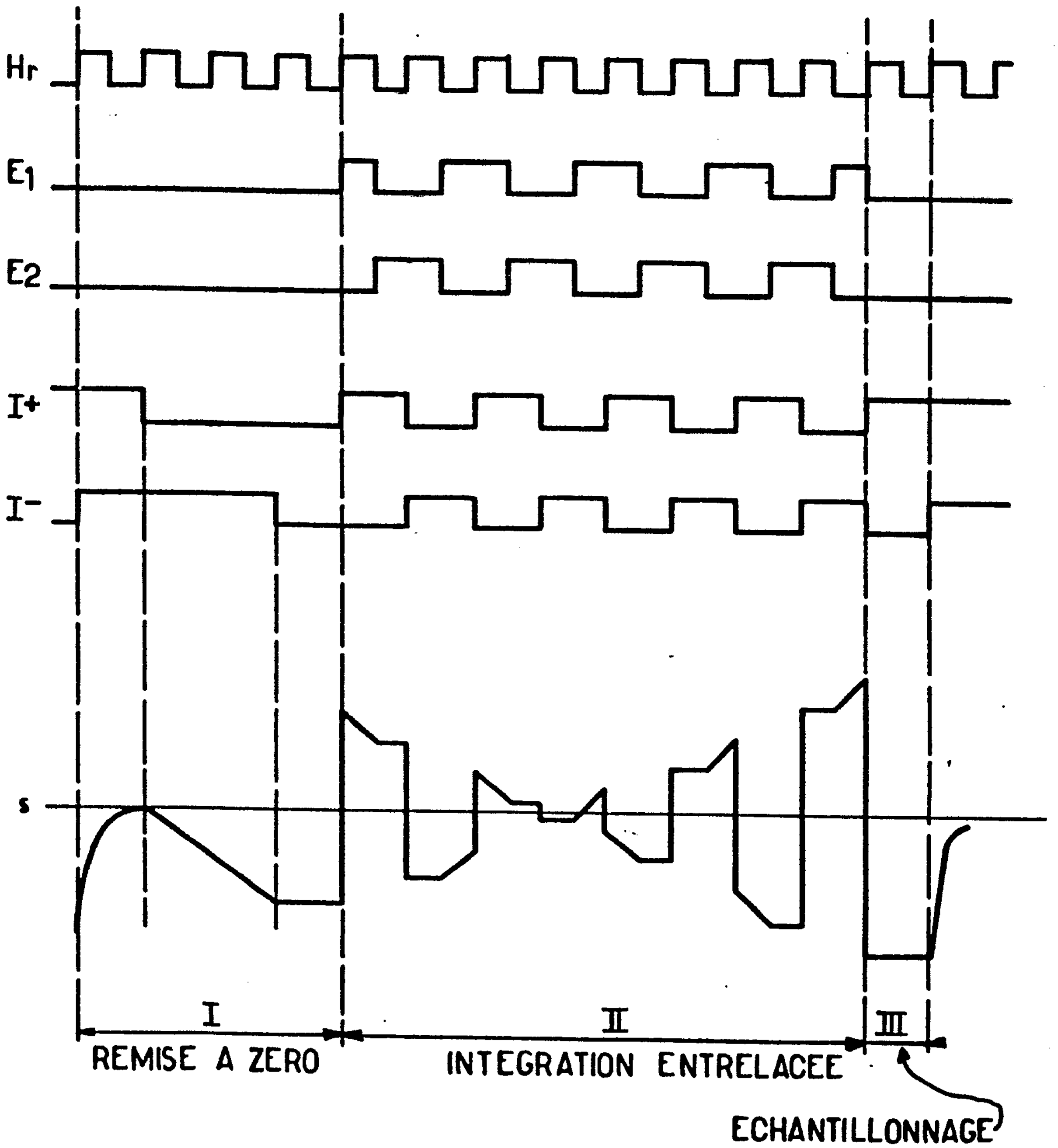

Hr
E1
E2
I+
I−
s
I
REMISE A ZERO
II
INTEGRATION ENTRELACEE
III
ECHANTILLONNAGE

FIG.12

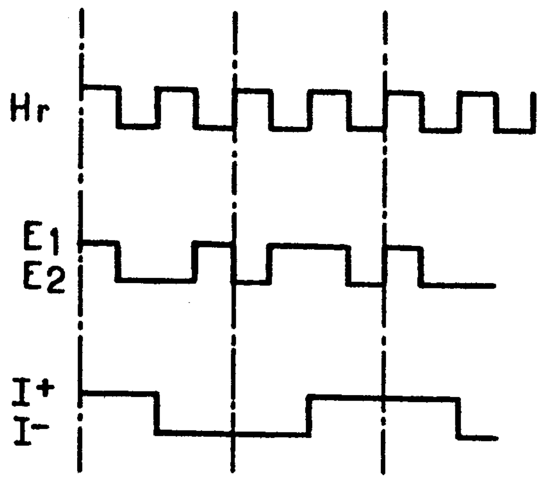


FIG.13

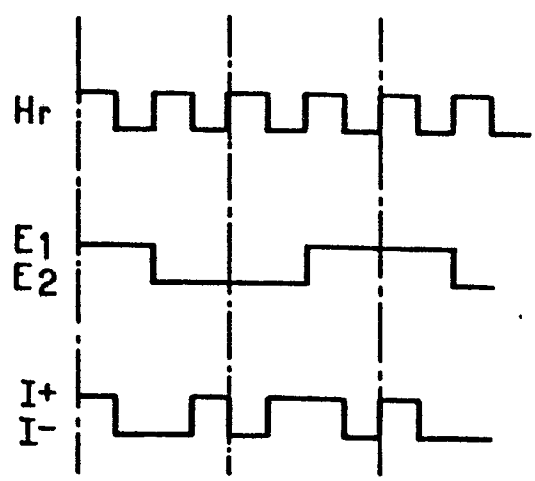

Office européen des brevets

# RAPPORT DE RECHERCHE EUROPEENNE

0207858

Numero de la demande

EP 86 40 1422

## DOCUMENTS CONSIDERES COMME PERTINENTS

| Catégorie | Citation du document avec indication, en cas de besoin des parties pertinentes | Revendication concernée | CLASSEMENT DE LA DEMANDE (Int Cl 4) |
|---|---|---|---|
| X | US-A-3 424 990 (A.S. ESCOBOSA) * Résumé; colonne 2, lignes 52-65; colonne 6, lignes 10-33; figures 5,6 * | 1 | H 03 D 1/22 |
| Y | | 1-3 | |
| | --- | | |
| Y | FR-A-2 361 770 (COMMISSARIAT A L'ENERGIE ATOMIQUE) * Page 6, lignes 28-41; page 7, lignes 1-31; figures 1-4 * | 1-3 | |
| | --- | | |
| A | US-A-4 010 424 (E.A. FAULKNER) | | |
| | --- | | |
| A | US-A-4 354 235 (T.R. BLAKESLEE) | | |
| | ----- | | |

DOMAINES TECHNIQUES RECHERCHES (Int. Cl 4)

H 03 D
G 01 R

Le present rapport de recherche a été établi pour toutes les revendications

| Lieu de la recherche | Date d'achèvement de la recherche | Examinateur |
|---|---|---|
| LA HAYE | 13-08-1986 | KAUFFMANN J. |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& membre de la même famille, document correspondant

OEB Form 1503 03 82